# EUROPEAN PATENT SPECIFICATION

(11) **EP 4 624 962 B1**
(45) Date of publication and mention of the grant of the patent: **01.07.2026**
(21) Application number: 24167192.4
(22) Date of filing: 28.03.2024
(51) Int. Cl.: G01R 31/40

(54) **METHOD FOR DETECTING A FAILURE OF A RECTIFIER**
VERFAHREN ZUM ERFASSEN EINES FEHLERS EINES GLEICHRICHTERS
PROCÉDÉ DE DÉTECTION D'UNE DÉFAILLANCE D'UN REDRESSEUR

(43) Date of publication of application: 01.10.2025
(73) Proprietor: MAHLE International GmbH, 70376 Stuttgart (DE)
(72) Inventor: BATISTIC, Zan, 5290 Sempeter pri Gorici (SI)
(74) Representative: BRP Renaud & Partner mbB Rechtsanwälte Patentanwälte Steuerberater

(56) References cited:
- CN-B- 105 223 459
- KR-B1- 100 374 904

## Description

The invention relates to a method for detecting a failure of a rectifier of an electric generator, especially of an alternator of a vehicle, according to claim 1. The invention also relates to the electric generator for carrying out the method.

An electrical generator - for example a vehicle alternator - usually comprises a rotor and a stator. The stator provides several individual phase voltages depending on the number of its turns, wherein the phase voltages are then summed and rectified in a rectifier to an output voltage. A voltage regulator then controls the output voltage and provides it, for example, for charging a battery. The voltage regulator can also detect over-voltage faults and/or under-voltage faults and/or phase regulation faults and/or field excitation overcurrent and/or field excitation open circuit and/or mechanical faults.

Faults are detected by monitoring different voltage amplitudes and voltage drops in the electrical generator. A fault is detected when a fault condition is present for longer than the defined confirmation interval. The faults are then communicated to the vehicle via a communication protocol or a charging fault indicator. However, most voltage regulators are not able to detect the failure of a single diode or a rectifier switching element of the rectifier. This is because generic voltage regulators cannot reliably distinguish between the high voltage ripple caused by a high load and a high speed condition and the high voltage ripple caused by a rectifier failure.

US 4 178 546 A proposes a method for detecting a rectifier failure that relies exclusively on the output voltage ripple signal. The failure of the rectifier is detected if the ripple frequency spectrum changes so that the f/6 frequency component - or different ratios for different failure modes - is presented. The method is disadvantageously not sufficiently robust because when the rectifier fails, the original amplitude of the ripple frequency of the output voltage decreases significantly and the new dominant frequency component caused by the rectifier failure becomes dominant. Hence, the original amplitude of the ripple frequency of the output voltage is difficult to detect.

In this context, the alternator represents a potentially critical system component that can require a service visit to the workshop in the event of a failure. Accordingly, rectifier failures should be predicted as early as possible and communicated to the vehicle operator.

KR10037490481 relates to diagnosing a fault in a phase controlled rectifier.

It is therefore the object of the invention to provide an improved or at least alternative embodiment for a method for detecting a failure of a rectifier of an electric generator of the generic type, in which the described disadvantages are overcome. It is also the object of the invention to provide a corresponding electrical generator.

These objects are solved according to the invention by the subject matter of the independent claims. Advantageous embodiments are the subject of the dependent claims.

The present invention is based on the general idea of a comparison of signal frequencies of the phase voltage signal and the output voltage signal to detect the failure of the rectifier caused by a short circuit or an open circuit of a diode or a rectifier switching element of the rectifier.

The method according to the invention is provided for detecting a failure of a rectifier of an electric generator, in particular of an alternator of a vehicle. In the method, the rectifier rectifies and sums up a plurality of phase voltages associated with the individual phases of the electric generator to an output voltage of the electrical generator. According to the invention, a first preliminary step and a second preliminary step are carried out simultaneously or one after another in any order. Subsequently, a comparison step is carried out in the method. In the first preliminary step, an output voltage signal limited to a predefined time interval is extracted i.e. captured from the output voltage. Then, a frequency distribution of the output voltage signal is calculated from the output voltage signal by means of a frequency analysis algorithm, in particular by means of a Fast-Fourier-Transform. A dominant frequency i.e. a dominant frequency component with the highest amplitude is then determined from the frequency distribution of the output voltage signal. In the second preliminary step, a phase voltage signal limited to a predefined time interval is extracted i.e. captured from one of the phase voltages i.e. from the single phase voltage. A mean frequency is then calculated from the phase voltage signal and a frequency tolerance band is calculated based on the mean frequency and/or on a frequency range of phase frequencies stored in a buffer. In the comparison step, it is checked whether the dominant frequency of the output voltage signal is within the frequency tolerance band of the phase voltage signal. Depending on whether the dominant frequency of the output voltage signal is within the frequency tolerance band of the phase voltage signal or not, it is determined whether there is a failure of the rectifier or not.

A permanent undetected failure of the rectifier of the electric generator can be problematic and should therefore be detected and communicated to the vehicle operator at an early stage. In the method according to the invention, the failure of at least one diode of the rectifier or at least one rectifier switching element of the rectifier is determined by comparing a ripple frequency of the output voltage and a phase frequency of the single phase voltage. The ripple frequency of the output voltage is thereby the frequency of the remaining i.e. residual ripple of the output voltage after summing and rectifying the phase voltages. The phase frequency of the single phase voltage is the frequency of the respective phase voltage.

During operation of the electric generator, the first preliminary step, the second preliminary step and the comparison step can be carried out continuously with a defined time interval. In other words, a plurality of iterations can be carried out in the method with a defined time interval. Thereby, the output voltage signal can be analyzed continuously in real time in predefined time windows i.e. intervals. Ad-ventitiously, the failure of the rectifier of the electric generator can be detected immediately and at an early stage.

The ratio between the ripple frequency of the output voltage and the phase frequency of the single phase voltage is linked to the physical properties of the generator - i.e. the number of stator phases of the stator - and remains constant over the entire life of the electrical generator. When a diode or rectifier switching element fails, the relationship between the ripple frequency of the output voltage and the phase frequency of the single phase voltage changes. Accordingly, the failure of the diode or the rectifier switching element and thus the failure of the rectifier can be reliably detected. The failure of the diode or the rectifier switching element can be in particular a short circuit or an open circuit.

A voltage regulator of the electric generator can be used to carry out the described method. In other words, the two preliminary steps and the comparison step can be performed by means of the voltage regulator of the electric generator. The output voltage and the single phase voltage can be detected at the voltage regulator of the electric generator.

The ripple frequency of the output voltage or the dominant frequency of the output voltage signal are determined in the first preliminary step. The output voltage corresponds to the summed and rectified voltage of the electrical generator. The output voltage is a direct voltage with a residual ripple. In the method, the residual ripple of the output voltage is decisive i.e. crucial. Based on the said residual ripple, the respective frequency distribution can be determined from the output voltage or from the extracted output voltage signal by means of a frequency analysis algorithm, in particular by means of a the Fast-Fourier-Transform. The dominant frequency with the highest amplitude of the frequency distribution is then determined. Thereby, the dominant frequency corresponds to the frequency of the residual ripple of the output voltage. After determining the dominant frequency, a frequency range search can be or is performed for an expected dominant frequency based on the frequency tolerance band of the phase voltage signal. The output voltage can be controlled by the voltage regulator of the electrical generator. The output voltage can be detected at a respective terminal of the voltage regulator of the electrical generator and further processed by the voltage regulator.

The phase frequency of the respective single phase voltage is determined in the second preliminary step. The phase voltage is provided by a stator of the electrical generator and corresponds to a single-phase voltage of the stator. The respective phase voltage is thereby an alternating voltage. The number of phase voltages depends on the design of the stator. Only one of the phase voltages i.e. only one of the respective single-phase voltages is sufficient for carrying out the method. The respective phase voltage can be detected at a respective terminal of the voltage regulator of the electrical generator and further processed by the voltage regulator.

Usually, the determination of the mean frequency of the phase voltage signal is already implemented in the voltage regulator and can be used in the method for further evaluation. The determination of the mean frequency can therefore be carried out in a manner already known to the person skilled in the art. The frequency tolerance band can thereby be determined based on the mean frequency of the phase voltage signal and/or on the frequency range of the of phase frequencies stored in a buffer i.e. on the frequency range of the phase frequencies used for the mean frequency calculation i.e. the range of the recorded frequency values in the phase frequency buffer depending on the physical properties of the generator. The frequency range of the phase frequencies can be based on the frequencies which are calculated in the iterations carried out in the method and stored i.e. recorded before in a phase frequency buffer. The phase frequency buffer can contain the phase frequency values for the past N readings. Based on the phase frequency values in the buffer, the mean value and the tolerance band can be calculated. The calculation of the frequency tolerance band can be implemented in such a way, that the constant changing of the alternator operational conditions can be taken into account. Because the change of the rotor speed changes the phase frequency and the voltage ripple frequency of the output voltage, by adaptive calculation of the tolerance band, a false-positive rectifier failure detection can be avoided. The physical properties of the generator do not change over its lifetime and can be considered i.e. taken into account via a constant factor. For example, this factor can consider how many individual phase voltages are summed up to the output voltage. The mean frequency and the frequency range of the phase frequencies stored in a buffer, on the other hand, can be used to consider the current working state of the electrical generator or the rectifier.

In the comparison step it is checked whether the dominant frequency of the output voltage signal is within the frequency tolerance band of the phase voltage signal. In other words, it is checked whether the output voltage is a result of rectification of all phase voltages. The ripple of the output voltage is caused by the respective positive and negative peaks of the respective individual phase voltages.

If the rectifier is OK, all phase voltages are summed and the residual ripple includes all peaks of the respective phase voltages. Accordingly, the dominant frequency is within the frequency tolerance band. If one of the phase voltages fails due to a short circuit or an open circuit of the diode or the rectifier switching element of the rectifier, the ripple of the output voltage lacks the corresponding positive and negative peaks of the failed phase voltage. As a result, the frequency of the output voltage ripple or the dominant frequency of the output voltage signal is reduced. Accordingly, the dominant frequency is no longer within the frequency tolerance band.

If the dominant frequency of the output voltage signal is within the frequency tolerance band of the phase voltage signal, then no failure of the rectifier is detected in the method. In other words, the output voltage is composed of all phase voltages i.e. no peaks of the individual phase voltages are missing in the residual ripple of the output voltage. Accordingly, all phase voltages are provided by the rectifier since all diode or rectifier switching elements function properly. No failure has occurred in the rectifier.

If the dominant frequency of the output voltage signal is not within the frequency tolerance band of the phase voltage signal, a failure of the rectifier is detected in the method. In other words, the output voltage is not composed of all phase voltages i.e. peaks of the individual phase voltages are missing in the residual ripple of the output voltage. Accordingly, not all phase voltages are provided by the rectifier because the diode or rectifier switching element is in short circuit or open circuit. A failure has occurred in the rectifier.

Before calculating the frequency distribution, the output voltage signal can be filtered by means of a low-pass filter. In this way, high-frequency components caused by the switching of the rectifier can be removed from the output voltage signal, thereby improving the accuracy of the evaluation. Before calculating the frequency distribution, the output voltage signal can be scaled to allow effective signal monitoring over the entire voltage range. The output voltage signal can be extracted i.e. captured as an analog signal and, before calculating the frequency distribution, converted to a digital signal using an analog-to-digital converter. Before calculating the frequency distribution, the output voltage signal can be stored in a storage.

Before calculating the mean frequency and frequency tolerance band, the phase voltage signal can be filtered using the low-pass filter to remove the high-frequency components from the phase voltage signal. Before calculating the mean frequency and frequency tolerance band, the phase voltage signal can be scaled to provide effective signal monitoring over the entire voltage range. The phase voltage signal can be extracted i.e. captured as an analog signal and, before calculating the mean frequency and frequency tolerance band, transformed to a digital pulse wave signal using a comparator. The pulse wave signal can then be used to calculate the mean frequency and frequency tolerance band as described above.

The mean frequency and the frequency tolerance band can be calculated from the phase voltage signal based on a frequency distribution of the phase voltage signal. As described above, the frequency tolerance band can be calculated depending on the physical properties of the generator. The physical properties of the generator do not change over its lifetime and can be considered i.e. taken into account via a constant factor. The current working state of the electrical generator or the rectifier can be taken into account i.e. considered via the frequency distribution of the phase voltage signal.

Before calculating the frequency distribution and calculating the mean frequency and frequency tolerance band of the phase voltage signal, the output voltage signal and the phase voltage signal can be synchronized with respect to the predefined time interval. The time synchronization can ensure that the output voltage signal and the phase voltage signal are captured in the same time interval. This prevents i.e. eliminates undesired time shifts between the two signals.

The invention also relates to an electrical generator, in particular to an alternator of a vehicle, with a rectifier. The electrical generator is provided to carry out the method described above. The electrical generator can thereby contain a stator and a rotor which can interact electromagnetically with one another. In this regard, the rectifier can get a plurality of phase voltages associated with the individual phases of the electrical generator, and can sum up and rectify the plurality of voltages associated with the individual phases into an output voltage. In addition, the electrical generator can include a voltage regulator. The voltage regulator can regulate the output voltage provided by the rectifier. In particular, the method described above can be performed using the voltage regulator. To avoid repetition, reference is made at this point to the above explanations.

Further important features and advantages of the invention are apparent from the subclaims, from the drawings, and from the accompanying figure description based on the drawings.

It is understood that the above features and those to be explained below can be used not only in the combination indicated in each case, but also in other combinations or on their own, without departing from the scope of the present invention.

Preferred embodiments of the invention are shown in the drawings and will be explained in more detail in the following description, wherein identical reference signs refer to identical or similar or functionally identical components.

It shows, in each case schematically
- Fig. 1: a circuit diagram of a generator according to the invention with a rectifier;
- Fig. 2: a diagram of a method according to the invention for detecting a failure of the rectifier of the electric generator;
- Fig. 3: voltages depending on time in the generator according to the invention with the rectifier functions properly;
- Fig. 4: a frequency distribution of an output voltage signal in the generator according to the invention with the rectifier functions properly;
- Fig. 5: voltages depending on time in the generator according to the invention with the rectifier having a diode in an open circuit;
- Fig. 6: voltages depending on time in the generator according to the invention with the rectifier with a diode in short circuit.

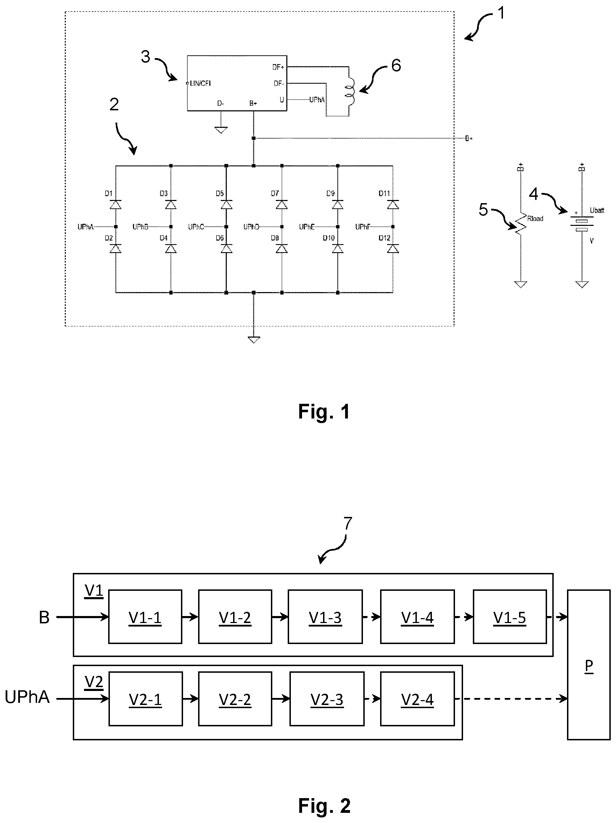

Fig. 1 shows a circuit diagram of a generator 1 according to the invention with a rectifier 2 and a voltage regulator 3. The rectifier 2 comprises several diodes D1, D2, D3, D4, D5, D6, D7, D8, D9, D10, D11, D12. A plurality of individual phase voltages UPhA, UPhB, UPhC, UPhD, UPhE, UPhF are provided to the rectifier 2 by a stator of the generator 1 - not shown here - which are rectified by the rectifier 2 and summed up to an output voltage B+. The output voltage B+ can thereby be regulated by the voltage regulator 3 and provided to a battery 4 or a load 5. The voltage regulator 3 can also provide a voltage DF to a rotor 6 of the generator 1. The phase voltages UPhA, UPhB, UPhC, UPhD, UPhE, UPhF are alternating voltages, the output voltage B+ is a direct voltage with a residual ripple and the voltage DF is a pulse width modulation signal.

Fig. 2 shows a diagram of a method 7 according to the invention for detecting a failure of the rectifier 2 of the electrical generator 1. By carrying out the method 7, the output voltage B+ and one of the phase voltages UPhA, UPhB, UPhC, UPhD, UPhE, UPhF - in this case the single phase voltage UPhA - are detected via the voltage regulator 3. The output voltage B+ is then processed in a first preliminary step V1 with several individual sub-steps V1-1, V1-2, V1-3, V1-4, V1-5 and the phase voltage UPhA is processed in a second preliminary step V2 with several individual sub-steps V2-1, V2-2, V2-3, V2-4. Subsequently, a comparison step P is carried out. In Fig. 2, analog signals are marked with a solid line and digital signals are marked with a broken line.

In the first preliminary step V1, an output voltage signal limited to a predefined time interval is extracted i.e. captured from the output voltage B+. The predefined time interval can be limited to a few milliseconds, 100 milliseconds for example. The output voltage B+ is a direct voltage with a residual ripple and the output voltage signal is analog.

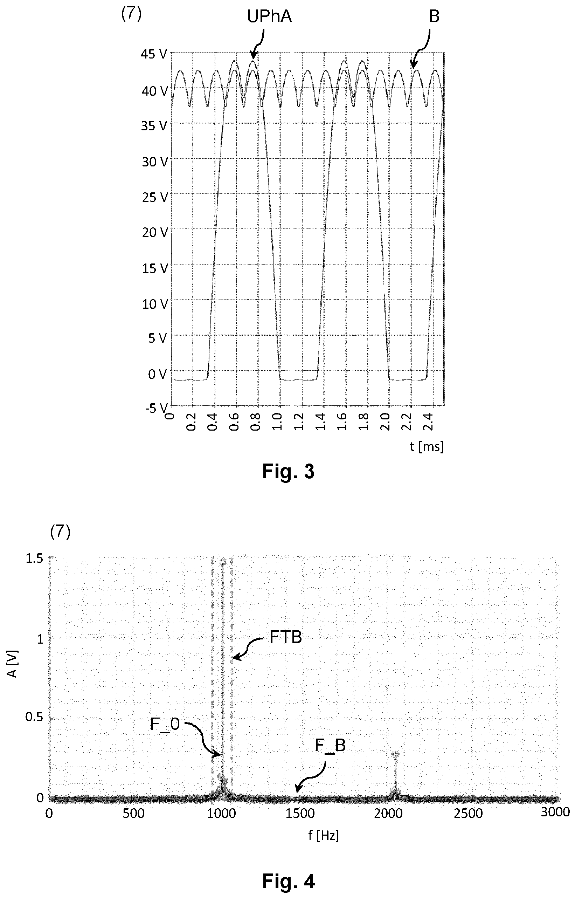

In sub-step V1-1, the extracted i.e. captured output voltage signal is filtered by means of a low-pass filter to remove high-frequency components caused by the switching of rectifier 1 and to increase the accuracy of the subsequent evaluation of the output voltage signal. In sub-step V1-2, the filtered output voltage signal is scaled to enable effective signal monitoring over the entire voltage range. In sub-step V1-3, the scaled output voltage signal is converted to a digital signal using an analog-to-digital converter. In sub-step V1-4, the digital output voltage signal is stored in a memory. In sub-step V1-5, a frequency distribution of the output voltage signal is calculated from the stored output voltage signal by means of a Fast-Fourier-Transform and a dominant frequency F_0 - see also Fig. 4 - with the highest amplitude is determined from the frequency distribution.

In the second preliminary step V2, a phase voltage signal limited to a predefined time interval is extracted i.e. captured from the phase voltage UPhA. The predefined time interval can be limited to a few milliseconds, 100 milliseconds for example. The output voltage signal and the phase voltage signal can be synchronized with respect to the predefined time interval to ensure the output voltage signal and the phase voltage signal are captured in the same time interval. The phase voltage UPhA is an alternating voltage and the phase voltage signal is analog.

In sub-step V2-1, the extracted phase voltage signal is filtered using the low-pass filter and the high-frequency components are removed from the phase voltage signal. In sub-step V2-2, the filtered phase voltage signal is scaled to enable effective signal monitoring over the entire voltage range. In sub-step V2-3, the scaled phase voltage signal is transformed to a digital pulse wave signal using a comparator. In sub-step V2-4, a mean frequency is calculated from the digital pulse-wave signal and, based on this, a frequency tolerance band FTB - see also Fig. 4. The frequency tolerance band FTB can be calculated based on the mean frequency of the phase voltage signal depending on the physical properties of the generator 1 and on a frequency range of the phase frequencies stored in a buffer i.e. the frequency range of the stored frequency values.

In the comparison step P - see also Fig. 4 - it is checked whether the dominant frequency F_0 of the output voltage signal determined in sub-step V1-5 lies within the frequency tolerance band FTB of the phase voltage signal determined in sub-step V2-4. If this is the case, rectifier 1 is working properly and no failure of rectifier 1 is detected. If this is not the case, the rectifier 1 does not function properly and a failure of the rectifier 1 is detected.

In Fig. 3 to Fig. 6 the method is described based on an example embodiment of the generator 1. In the shown exampled embodiment, the stator of the generator 1 contains 3 phase delta winding. It goes without saying, that in another embodiment the singles values would change. Nevertheless, the steps V1 and V2 and P described above remain identical independent of the concrete embodiment of the electrical generator.

Fig. 3 shows the phase voltage UPhA and the output voltage B+ depending on time t in the exampled generator 1, wherein the rectifier 2 functions i.e. works properly. As can be seen here, the residual ripple of the output voltage B+ is composed of the positive and negative peaks of the individual phase voltages UPhA, UPhB, UPhC, UPhD, UPhE, UPhF. As a result, the frequency of the ripple of the output voltage B+ is larger than the frequency of the phase voltages UPhA, UPhB, UPhC, UPhD, UPhE, UPhF by a fixed factor. In this embodiment, the said fixed factor is equal to 6.

Fig. 4 shows a frequency distribution F_B of the output voltage signal in the exampled generator 1, wherein the rectifier 2 functions i.e. works properly. The frequency distribution F_B of the output voltage signal has a dominant frequency F_0 at about 1000 Hz, which lies within the frequency tolerance band FTB of the phase voltage signal. Accordingly, the rectifier 2 functions properly and there is no failure of the rectifier 2. As described above, the calculated frequency tolerance band FTB is based on the mean frequency of the phase voltage signal and the physical characteristics of the generator 1 and on the frequency range of phase frequencies stored in a buffer i.e. the frequency range of the stored frequency values.

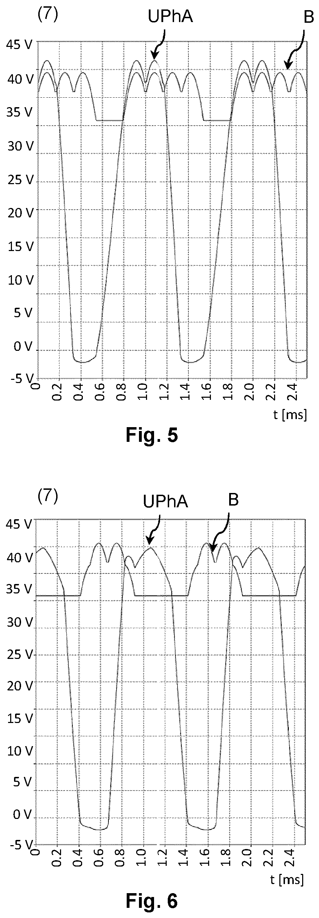

Fig. 5 shows the phase voltage UPhA and the output voltage B+ depending on time t in the exampled generator 1, wherein the rectifier 2 does not function properly. Here, a diode of the rectifier 2 is an open circuit. As can be seen, in the output voltage B+ ripples, some positive and negative peaks of the phase voltages UPhA, UPhB, UPhC, UPhD, UPhE, UPhE drop out. This also changes the frequency of the output voltage ripple and, correspondingly, the dominant frequency F_0 in the frequency distribution F_B of the output voltage signal. As a result, in the frequency domain, the dominant frequency F_0 of the output voltage signal does not lie within the frequency tolerance band FTB of the phase voltage signal. Accordingly, the rectifier 2 does not function properly and there is a failure of the rectifier 2.

Fig. 6 shows the phase voltage UPhA and the output voltage B+ depending on time t in the exampled generator 1, wherein the rectifier 2 does not function properly. Here, a diode of the rectifier 2 is in short circuit. Again, the frequency of the output voltage ripple changes and, correspondingly, the dominant frequency F_0 in the frequency distribution F_B of the output voltage signal changes. Accordingly, in the frequency domain, the dominant frequency F_0 of the output voltage signal does not lie within the frequency tolerance band FTB of the phase voltage signal. Accordingly, the rectifier 2 does not function properly and there is a failure of the rectifier 2.

## Claims

1. Method (7) for detecting a failure of a rectifier (2) of an electric generator (1), especially of an alternator of a vehicle,
- wherein the rectifier (2) rectifies and sums up a plurality of phase voltages (UPhA, UPhB, UPhC, UPhD, UPhE, UPhF) associated with the individual phases of the electrical generator (1) to an output voltage (B+) of the electrical generator (1),
wherein in a first preliminary step (V1):
- an output voltage signal limited to a predefined time interval is extracted from the output voltage (B+),
- a frequency distribution (F_B) of the output voltage signal is calculated from the output voltage signal by means of a frequency analysis algorithm, in particular by means of a Fast-Fourier-Transform,
- a dominant frequency (F_0) with the highest amplitude is determined from the frequency distribution (F_B) of the output voltage signal, wherein the method is **characterized**
**in that** in a second preliminary step (V2):
- a phase voltage signal limited to a predefined time interval is extracted from one of the phase voltages (UPhA),
- a mean frequency is calculated from the phase voltage signal and a frequency tolerance band (FTB) is calculated based on the mean frequency and/or on a frequency range of phase frequencies stored in a buffer; and
**in that** in a comparison step (P):
- it is checked whether the dominant frequency (F_0) of the output voltage signal is within the frequency tolerance band (FTB) of the phase voltage signal, and
- depending on whether the dominant frequency (F_0) of the output voltage signal is within the frequency tolerance band (FTB) of the phase voltage signal or not, it is determined whether there is a failure of the rectifier (2) or not.

2. Method (7) according to claim 1,
**characterized**
- **in that**, if the dominant frequency (F_0) of the output voltage signal is within the frequency tolerance band (FTB) of the phase voltage signal, no failure of the rectifier (2) is detected, and
- **in that**, if the dominant frequency (F_0) of the output voltage signal is not within the frequency tolerance band (FTB) of the phase voltage signal, a failure of the rectifier (2) is detected.

3. Method (7) according to claim 1 or 2,
**characterized**
- **in that**, before calculating the frequency distribution (F_B), the output voltage signal is filtered by means of a low-pass filter, and/or
- **in that**, before calculating the mean frequency and the frequency tolerance band (FTB), the phase voltage signal is filtered by means of a low-pass filter.

4. Method (7) according to any one of the preceding claims,
**characterized**
- **in that**, before calculating the frequency distribution (F_B), the output voltage signal is scaled, and/or
- **in that**, before calculating the mean frequency and the frequency tolerance band (FTB), the phase voltage signal is scaled.

5. Method (7) according to any one of the preceding claims,
**characterized**
**in that** the output voltage signal is extracted as an analog signal and, before calculating the frequency distribution (F_B), is converted to a digital signal by means of an analog-to-digital converter.

6. Method (7) according to any one of the preceding claims,
**characterized**
**in that**, before calculating the frequency distribution (F_B), the output voltage signal is stored in a storage.

7. Method (7) according to any one of the preceding claims,
**characterized**
**in that** the phase voltage signal is extracted as an analog signal and, before calculating the mean frequency and the frequency tolerance band (FTB), is transformed to a digital pulse wave signal by means of a comparator.

8. Method (7) according to any one of the preceding claims,
**characterized**
**in that**, before calculating the frequency distribution (F_B) and before the calculating of the mean frequency and the frequency tolerance band (FTB) of the phase voltage signal, the output voltage signal and the phase voltage signal are synchronized with respect to the predefined time interval.

9. Method (7) according to any one of the preceding claims,
**characterized**
**in that** the mean frequency and the frequency tolerance band (FTB) are calculated from the phase voltage signal based on a frequency distribution of the phase voltage signal.

10. Method (7) according to any one of the preceding claims,
**characterized**
- **in that** the output voltage (B+) and the respective phase voltage (UPhA) are detected at a voltage regulator (3) of the electrical generator (1), and/or
- **in that** the first preliminary step (V1) and the second preliminary step (V2) and the comparison step (P) are carried out by means of a voltage regulator (3) of the electrical generator (1).

11. Method (7) according to any one of the preceding claims,
**characterized**
**in that**, during operation of the electric generator (1), the first preliminary step (V1), the second preliminary step (V2) and the comparison step (P) are carried out continuously with a defined time interval in the method (7).

12. Electric generator (1), especially an alternator of a vehicle, with a rectifier (2), wherein the electric generator (1) is provided for carrying out the method (7) according to one of the preceding claims.

## Patentansprüche

1. Verfahren (7) zum Erkennen eines Fehlers eines Gleichrichters (2) eines elektrischen Generators (1), insbesondere einer Lichtmaschine eines Kraftfahrzeugs,
- wobei der Gleichrichter (2) eine Vielzahl von Phasenspannungen (UPhA, UPhB, UPhC, UPhD, UPhE, UPhF), die den einzelnen Phasen des elektrischen Generators (1) zugeordnet sind, gleichrichtet und zu einer Ausgangsspannung (B+) des elektrischen Generators (1) summiert,
wobei
in einem ersten vorbereitenden Schritt (V1):
- ein Ausgangsspannungssignal, das auf ein vordefiniertes Zeitintervall begrenzt ist, aus der Ausgangsspannung (B+) extrahiert wird,
- eine Frequenzverteilung (F_B) des Ausgangsspannungssignals mittels eines Frequenzanalysealgorithmus, insbesondere mittels einer Fast-FourierTransformation, aus dem Ausgangsspannungssignal berechnet wird,
- eine dominante Frequenz mit der höchsten Amplitude aus der Frequenzverteilung (F_B) des Ausgangsspannungssignals bestimmt wird, wobei das Verfahren **dadurch gekennzeichnet ist,**
**dass** in einem zweiten vorbereitenden Schritt (V2):
- ein Phasenspannungssignal, das auf ein vordefiniertes Zeitintervall begrenzt ist, aus einer der Phasenspannungen (UPhA) extrahiert wird,
- eine mittlere Frequenz aus dem Phasenspannungssignal berechnet wird, und ein Frequenztoleranzband (FTB) auf Basis der mittleren Frequenz und/oder eines Frequenzbereichs von Phasenfrequenzen, die in einem Puffer gespeichert sind, berechnet wird; und
**dass** in einem Vergleichsschritt (P):
- geprüft wird, ob die dominante Frequenz des Ausgangsspannungssignals innerhalb des Frequenztoleranzbandes (FTB) des Phasenspannungssignals liegt, und
- abhängig davon, ob die dominante Frequenz des Ausgangsspannungssignals innerhalb des Frequenztoleranzbandes (FTB) des Phasenspannungssignals liegt oder nicht, bestimmt wird, ob ein Fehler des Gleichrichters (2) vorliegt oder nicht.

2. Verfahren (7) nach Anspruch 1,
**dadurch gekennzeichnet,**
- **dass** wenn die dominante Frequenz des Ausgangsspannungssignals innerhalb des Frequenztoleranzbandes (FTB) des Phasenspannungssignals liegt, kein Fehler des Gleichrichters (2) erkannt wird, und
- **dass** wenn die dominante Frequenz des Ausgangsspannungssignals nicht innerhalb des Frequenztoleranzbandes (FTB) des Phasenspannungssignals liegt, ein Fehler des Gleichrichters (2) erkannt wird.

3. Verfahren (7) nach Anspruch 1 oder 2,
**dadurch gekennzeichnet,**
- **dass** vor dem Berechnen der Frequenzverteilung (F_B) das Ausgangsspannungssignal mittels eines Tiefpassfilters gefiltert wird, und/oder
- **dass** vor dem Berechnen der mittleren Frequenz und des Frequenztoleranzbandes (FTB) das Phasenspannungssignal mittels eines Tiefpassfilters gefiltert wird.

4. Verfahren (7) nach einem der vorstehenden Ansprüche,
**dadurch gekennzeichnet,**
- **dass** vor dem Berechnen der Frequenzverteilung (F_B) das Ausgangsspannungssignal skaliert wird, und/oder
- **dass** vor dem Berechnen der mittleren Frequenz und des Frequenztoleranzbandes (FTB) das Phasenspannungssignal skaliert wird.

5. Verfahren (7) nach einem der vorstehenden Ansprüche,
**dadurch gekennzeichnet,**
**dass** das Ausgangsspannungssignal als analoges Signal extrahiert und vor dem Berechnen der Frequenzverteilung (F_B) mittels eines Analog-Digital-Wandlers in ein digitales Signal umgewandelt wird.

6. Verfahren (7) nach einem der vorstehenden Ansprüche,
**dadurch gekennzeichnet,**
**dass** vor dem Berechnen der Frequenzverteilung (F_B) das Ausgangsspannungssignal in einem Speicher gespeichert wird.

7. Verfahren (7) nach einem der vorstehenden Ansprüche,
**dadurch gekennzeichnet,**
**dass** das Phasenspannungssignal als analoges Signal extrahiert und vor dem Berechnen der mittleren Frequenz und des Frequenztoleranzbandes (FTB) mittels eines Komparators in ein digitales Pulswellensignal transformiert wird.

8. Verfahren (7) nach einem der vorstehenden Ansprüche,
**dadurch gekennzeichnet,**
**dass** vor dem Berechnen der Frequenzverteilung (F_B) und vor dem Berechnen der mittleren Frequenz und des Frequenztoleranzbandes (FTB) des Phasenspannungssignals das Ausgangsspannungssignal und das Phasenspannungssignal in Bezug auf das vordefinierte Zeitintervall synchronisiert werden.

9. Verfahren (7) nach einem der vorstehenden Ansprüche,
**dadurch gekennzeichnet,**
**dass** die mittlere Frequenz und das Frequenztoleranzband (FTB) auf Basis einer Frequenzverteilung des Phasenspannungssignals aus dem Phasenspannungssignal berechnet werden.

10. Verfahren (7) nach einem der vorstehenden Ansprüche,
**dadurch gekennzeichnet,**
- **dass** die Ausgangsspannung (B+) und die jeweilige Phasenspannung (UPhA) an einem Spannungsregler (3) des elektrischen Generators (1) erkannt werden, und/oder
- **dass** der erste vorbereitende Schritt (V1) und der zweite vorbereitende Schritt (V2) und der Vergleichsschritt (P) mittels eines Spannungsreglers (3) des elektrischen Generators (1) ausgeführt werden.

11. Verfahren (7) nach einem der vorstehenden Ansprüche,
**dadurch gekennzeichnet,**
**dass** während des Betriebs des elektrischen Generators (1) der erste vorbereitende Schritt (V1), der zweite vorbereitende Schritt (V2) und der Vergleichsschritt (P) kontinuierlich mit einem definierten Zeitintervall in dem Verfahren (7) ausgeführt werden.

12. Elektrischer Generator (1), insbesondere eine Lichtmaschine eines Kraftfahrzeugs, mit einem Gleichrichter (2), wobei der elektrische Generator (1) zum Ausführen des Verfahrens (7) nach einem der vorstehenden Ansprüche bereitgestellt ist.

## Revendications

1. Procédé (7) de détection d'une défaillance d'un redresseur (2) d'un générateur électrique (1), notamment d'un alternateur d'un véhicule,
- dans lequel le redresseur (2) redresse et additionne une pluralité de tensions de phase (UPhA, UPhB, UPhC, UPhD, UPhE, UPhF) associées aux phases individuelles du générateur électrique (1) pour obtenir une tension de sortie (B+) du générateur électrique (1),
dans lequel
dans une première étape préliminaire (V1) :
- un signal de tension de sortie limité à un intervalle de temps prédéfini est extrait de la tension de sortie (B+),
- une distribution de fréquence (F_B) du signal de tension de sortie est calculé à partir du signal de tension de sortie au moyen d'un algorithme d'analyse de fréquence, notamment au moyen d'une transformée de Fourier rapide.
- une fréquence dominante avec l'amplitude la plus élevée est déterminée à partir de la distribution de fréquence (F_B) du signal de tension de sortie, dans lequel le procédé est **caractérisé**
**en ce que** dans une seconde étape préliminaire (V2) :
- un signal de tension de phase limité à un intervalle de temps prédéfini est extrait de l'une des tensions de phase (UPhA),
- une fréquence moyenne est calculée à partir du signal de tension de phase et une bande de tolérance de fréquence (FTB) est calculée sur la base de la fréquence moyenne et/ou sur une plage de fréquences de phase stockées dans une mémoire tampon ; et
**en ce que** dans une étape de comparaison (P) :
- il est vérifié que la fréquence dominante du signal de tension de sortie se situe dans la bande de tolérance de fréquence (FTB) du signal de tension de phase, et
- en fonction de si la fréquence dominante (F_0) du signal de tension de sortie se situe dans la bande de tolérance de fréquence (FTB) du signal de tension de phase ou non, il est déterminé si le redresseur (2) présente une défaillance ou non.

2. Procédé (7) selon la revendication 1,
**caractérisé**
- **en ce que**, si la fréquence dominante du signal de tension de sortie se situe dans la bande de tolérance de fréquence (FTB) du signal de tension de phase, aucune défaillance du redresseur (2) n'est détectée, et
- **en ce que**, si la fréquence dominante du signal de tension de sortie n'est pas dans la bande de tolérance de fréquence (FTB) du signal de tension de phase, une défaillance du redresseur (2) est détectée.

3. Procédé (7) selon la revendication 1 ou 2,
**caractérisé**
- **en ce que**, avant de calculer la distribution de fréquence (F_B), le signal de tension de sortie est filtré au moyen d'un filtre passe-bas, et/ou
- **en ce que**, avant de calculer la fréquence moyenne et la bande de tolérance de fréquence (FTB), le signal de tension de phase est filtré au moyen d'un filtre passe-bas.

4. Procédé (7) selon l'une quelconque des revendications précédentes,
**caractérisé**
- **en ce que**, avant de calculer la distribution de fréquence (F_B), le signal de tension de sortie est mis à l'échelle, et/ou
- **en ce que**, avant de calculer la fréquence moyenne et la bande de tolérance de fréquence (FTB), le signal de tension de phase est mis à l'échelle.

5. Procédé (7) selon l'une quelconque des revendications précédentes,
**caractérisé**
**en ce que** le signal de tension de sortie est extrait sous forme de signal analogique et, avant de calculer la distribution de fréquence (F_B), est converti en un signal numérique au moyen d'un convertisseur analogique-numérique.

6. Procédé (7) selon l'une quelconque des revendications précédentes,
**caractérisé**
**en ce que**, avant de calculer la distribution de fréquence (F_B), le signal de tension de sortie est stocké dans un dispositif de stockage.

7. Procédé (7) selon l'une quelconque des revendications précédentes,
**caractérisé**
**en ce que** le signal de tension de phase est extrait sous forme de signal analogique et, avant de calculer la fréquence moyenne et la bande de tolérance de fréquence (FTB), est transformé en un signal d'onde d'impulsion numérique au moyen d'un comparateur.

8. Procédé (7) selon l'une quelconque des revendications précédentes,
**caractérisé**
**en ce que**, avant de calculer la distribution de fréquence (F_B) et avant de calculer la fréquence moyenne et de la bande de tolérance de fréquence (FTB) du signal de tension de phase, le signal de tension de sortie et le signal de tension de phase sont synchronisés par rapport à l'intervalle de temps prédéfini.

9. Procédé (7) selon l'une quelconque des revendications précédentes,
**caractérisé**
**en ce que** la fréquence moyenne et la bande de tolérance de fréquence (FTB) sont calculées à partir du signal de tension de phase sur la base d'une distribution de fréquence du signal de tension de phase.

10. Procédé (7) selon l'une quelconque des revendications précédentes,
**caractérisé**
- **en ce que** la tension de sortie (B+) et la tension de phase respective (UPhA) sont détectées au niveau d'un régulateur de tension (3) du générateur électrique (1), et/ou
- **en ce que** la première étape préliminaire (V1) et la seconde étape préliminaire (V2) et l'étape de comparaison (P) sont réalisées au moyen d'un régulateur de tension (3) du générateur électrique (1).

11. Procédé (7) selon l'une quelconque des revendications précédentes,
**caractérisé**
**en ce que**, pendant le fonctionnement du générateur électrique (1), la première étape préliminaire (V1), la seconde étape préliminaire (V2) et l'étape de comparaison (P) sont réalisées en continu avec un intervalle de temps défini dans le procédé (7).

12. Générateur électrique (1), notamment un alternateur d'un véhicule, avec un redresseur (2), dans lequel le générateur électrique (1) est prévu pour mettre en œuvre le procédé (7) selon l'une quelconque des revendications précédentes.
